# EUROPEAN PATENT APPLICATION

(11) **EP 4 769 946 A1**
(43) Date of publication of application: **01.07.2026**
(21) Application number: 25227349.5
(22) Date of filing: 29.12.2025
(51) Int. Cl.: H03K 17/06, H10D 62/17, H10D 62/85, H10D 84/80, H03K 17/687

(54) **DRIVING CHIP, BIDIRECTIONAL POWER APPARATUS, AND MANUFACTURING METHOD**

(30) Priority: 31.12.2024 CN 202411998922
(71) Applicant: Silergy Semiconductor Technology (Hangzhou) Ltd, Hangzhou City, Zhejiang Province 310051 (CN)
(72) Inventor: ZHANG, Li, Hangzhou City,Zhejiang Province, 310051 (CN); ZHAO, Qiyue, Hangzhou City,Zhejiang Province, 310051 (CN); WANG, Xiao, Hangzhou City,Zhejiang Province, 310051 (CN); BO, Pengxiang, Hangzhou City,Zhejiang Province, 310051 (CN)
(74) Representative: Viering, Jentschura & Partner mbB Patent- und Rechtsanwälte

(57) **Abstract**

A driving chip, a bidirectional power apparatus, and a manufacturing method are provided. The driving chip can drive a bidirectional power device and modulate a substrate potential of the bidirectional power device. The bidirectional power device comprises a first power end, a second power end, a control end, and a substrate potential end. The driving chip comprises a driving circuit and a substrate potential modulation circuit. The driving circuit and the substrate potential modulation circuit are formed in the same substrate. The substrate potential modulation circuit receives signals from the control end and from the first power end and/or the second power end, and is connected to the substrate potential end, such that a voltage at the substrate potential end of the bidirectional power device is substantially consistent with a lowest voltage among voltages at the control end, the first power end, and the second power end. The present disclosure provides a technical solution that can control the substrate potential of the bidirectional power device without increasing additional costs or parasitic parameters of the bidirectional power device.

## Description

### FIELD OF THE INVENTION

The present discloses relates to the technical field of integrated circuit design, and more particularly to a driving chip, a bidirectional power apparatus, a manufacturing method for a driving chip, and a manufacturing method for a bidirectional power apparatus.

### BACKGROUND OF THE INVENTION

With increasing requirements for the size and energy efficiency of power devices, wide bandgap semiconductor Gallium Nitride (GaN) devices, due to their lower power loss and faster switching capability, have been widely applied in power conversion apparatuses.

In certain applications requiring bidirectional switching, a Gallium Nitride High Electron Mobility Transistor (GaN HEMT) device can be equivalently regarded as two transistors coupled in a back-to-back series configuration. Compared with two Si-based transistors that are connected in series, a Bipolar Gallium Nitride High Electron Mobility Transistor (Bi-GaN HEMT) offers lower power consumption and a more compact size.

However, during the switching process, if the substrate of the Bi-GaN HEMT is floating, charges will accumulate in the substrate during device switching, which adversely affects the switching performance and causes degradation of dynamic resistance. In conventional power devices, in order to avoid the impact of substrate floating on device performance and reliability, the substrate is typically maintained at the same potential as the source. Yet, in bidirectional power devices, since the source and drain switch according to the operating state of the circuit, the substrate cannot be directly electrically connected to either the source or the drain.

At present, most bidirectional power devices incorporate internal potential management structures to regulate the substrate potential. However, such clamping circuits not only introduce additional parasitic capacitance, thereby affecting device efficiency, but also increase the overall cost of the bidirectional power device.

### SUMMARY OF THE INVENTION

The present disclosure provides a driving chip, a bidirectional power apparatus, and a manufacturing method, which offer a technical solution that can modulate the substrate potential without increasing additional costs or parasitic parameters of the bidirectional power device.

In a first aspect, the present disclosure provides a driving chip for driving a bidirectional power device and modulating a substrate potential of the bidirectional power device. The bidirectional power device includes a first power end, a second power end, a control end, and a substrate potential end. The driving chip includes a driving circuit and a substrate potential modulation circuit.

The driving circuit and the substrate potential modulation circuit are formed on a same substrate.

The substrate potential modulation circuit receives signals from the control end and from the first power end and/or the second power end, and is connected to the substrate potential end, such that a voltage at the substrate potential end of the bidirectional power device is substantially consistent with a lowest voltage among voltages at the control end, the first power end, and the second power end.

In an optional implementation, the substrate potential modulation circuit includes a switching module, a first end of the switching module is electrically connected to whichever of the first power end or the second power end has the lower voltage, a second end of the switching module is electrically connected to the substrate potential end of the bidirectional power device, and a control end of the switching module is electrically connected to the control end of the bidirectional power device.

In an optional implementation, the switching module includes a first transistor, a first end of the first transistor is electrically connected to one of the first power end and the second power end of the bidirectional power device, a second end of the first transistor is electrically connected to the substrate potential end of the bidirectional power device, and a control end of the first transistor is electrically connected to the control end of the bidirectional power device.

In an optional implementation, the first transistor includes a first well region of a first doping type that is located in the substrate, first source/drain regions of a second doping type that are located in the first well region, and a first gate that is disposed between the first source/drain regions. The first gate is the control end of the first transistor.

In an optional implementation, the switching module further includes a second transistor, a first end of the second transistor is electrically connected to the other one of the first power end and the second power end of the bidirectional power device, a second end of the second transistor is electrically connected to the substrate potential end of the bidirectional power device, and a control end of the second transistor is electrically connected to the control end of the bidirectional power device.

In an optional implementation, the second transistor includes a second well region of a first doping type that is located in the substrate, second source/drain regions of a second doping type that are located in the second well region, and a second gate that is disposed on an upper surface of the substrate and between the second source/drain regions. The second gate is the control end of the second transistor.

In an optional implementation, the switching module further includes a diode, a cathode of the diode is electrically connected to the control end of the first transistor and/or the control end of the second transistor, and an anode of the diode is electrically connected to the substrate potential end of the bidirectional power device.

In an optional implementation, the diode is a PN junction diode or a Schottky diode.

In an optional implementation, the driving circuit includes a third transistor and a fourth transistor. A second end of the third transistor is electrically connected to a first end of the fourth transistor, and is further electrically connected to the substrate potential end and the control end of the bidirectional power device, so as to drive the bidirectional power device.

A control end of the third transistor is electrically connected to a control end of the fourth transistor.

In a second aspect, the present disclosure provides a bidirectional power apparatus, including a bidirectional power device and a driving chip as described in any one of the examples provided in the first aspect of the present disclosure. The driving chip is configured to drive the bidirectional power device and to modulate the substrate potential of the bidirectional power device.

In a third aspect, the present disclosure provides a method for manufacturing a driving chip, including: providing a substrate; and forming a driving circuit and a substrate potential modulation circuit in the substrate. The driving circuit is configured to drive a bidirectional power device, and the substrate potential modulation circuit is configured to modulate a substrate potential of the bidirectional power device.

The bidirectional power device includes a first power end, a second power end, a control end, and a substrate potential end. The substrate potential modulation circuit receives signals from the control end and from the first power end and/or the second power end, and is connected to the substrate potential end, such that the substrate potential end of the bidirectional power device is substantially consistent with a lowest voltage among voltages at the first power end and the second power end.

In an optional implementation, the substrate potential modulation circuit includes a first transistor and/or a second transistor, and the driving circuit includes a third transistor and a fourth transistor.

The step of forming the driving circuit and the substrate potential modulation circuit in the substrate includes: simultaneously forming first source/drain regions and/or second source/drain regions, third source/drain regions, and fourth source/drain regions in the substrate, wherein the first source/drain regions are a first end and a second end of the first transistor, the second source/drain regions are a first end and a second end of the second transistor, the third source/drain regions are a first end and a second end of the third transistor, and the fourth source/drain regions are a first end and a second end of the fourth transistor; and simultaneously forming a first gate and/or a second gate, a third gate, and a fourth gate on an upper surface of the substrate, wherein the first gate is a control end of the first transistor, the second gate is a control end of the second transistor, the third gate is a control end of the third transistor, and the fourth gate is a control end of the fourth transistor.

In an optional implementation, the step of simultaneously forming the first source/drain regions and/or the second source/drain regions, the third source/drain regions, and the fourth source/drain regions in the substrate includes: forming a first well region and/or a second well region, a third well region, and a fourth well region in the substrate; and simultaneously forming the first source/drain regions in the first well region and/or the second source/drain regions in the second well region, the third source/drain regions in the third well region, and the fourth source/drain regions in the fourth well region.

In an optional implementation, the first well region and the second well region have the same dopant ion type.

The third well region and the fourth well region have opposite dopant ion types.

The first source/drain regions and the first well region have opposite dopant ion types.

The second source/drain regions and the second well region have opposite dopant ion types.

The third source/drain regions and the third well region have opposite dopant ion types.

The fourth source/drain regions and the fourth well region have opposite dopant ion types.

In an optional implementation, the substrate potential modulation circuit further includes a diode.

When forming the first well region and/or the second well region, the third well region, and the fourth well region in the substrate, the method includes: simultaneously forming a fifth well region in the substrate.

When forming the first source/drain regions in the first well region and/or the second source/drain regions in the second well region, forming the third source/drain regions in the third well region, and forming the fourth source/drain regions in the fourth well region, the method includes: simultaneously forming a first doped region and/or a second doped region in the fifth well region.

In an optional implementation, the fifth well region has a dopant ion type opposite to that of the first well region and the second well region.

The first doped region and the second doped region have opposite dopant ion types.

In an optional implementation, after simultaneously forming the first source/drain regions in the first well region and/or the second source/drain regions in the second well region, the third source/drain regions in the third well region, and the fourth source/drain regions in the fourth well region, the method further includes: forming a dielectric layer on the upper surface of the substrate.

In an optional implementation, the step of simultaneously forming the first gate and/or the second gate, the third gate, and the fourth gate on the upper surface of the substrate includes: simultaneously forming the first gate and/or the second gate, the third gate, and the fourth gate on an upper surface of the dielectric layer.

In an optional implementation, the method further includes respectively and simultaneously forming, on upper surfaces of the first source/drain regions and/or the second source/drain regions, the third source/drain regions, and the fourth source/drain regions, first metal electrodes and/or second metal electrodes, third metal electrodes, and fourth metal electrodes penetrating the dielectric layer.

The first metal electrodes are located on two sides of the first gate and are electrically connected to the first source/drain regions and/or the second metal electrodes are located on two sides of the second gate and are electrically connected to the second source/drain regions; the third metal electrodes are located on two sides of the third gate and are electrically connected to the third source/drain regions; and the fourth metal electrodes are located on two sides of the fourth gate and are electrically connected to the fourth source/drain regions.

In an optional implementation, when respectively and simultaneously forming, on upper surfaces of the first source/drain regions and/or the second source/drain regions, the third source/drain regions, and the fourth source/drain regions, first metal electrodes and/or second metal electrodes, third metal electrodes, and fourth metal electrodes penetrating the dielectric layer, the method includes: simultaneously forming an anode metal electrode and a cathode metal electrode that penetrate the dielectric layer on an upper surface of the fifth well region.

The anode metal electrode is formed on an upper surface of the first doped region and is electrically connected to the fifth well region; and/or the cathode metal electrode is formed on an upper surface of the second doped region and is electrically connected to the fifth well region.

In an optional implementation, after simultaneously forming the first well region and/or the second well region in the substrate and simultaneously forming the third well region and the fourth well region in the substrate, the method further includes: simultaneously forming an isolation region between two adjacent well regions among the first well region and/or the second well region, the third well region, and the fourth well region.

In a fourth aspect, the present disclosure provides a method for manufacturing a bidirectional power apparatus. The bidirectional power apparatus includes a bidirectional power device and a driving chip as described in any one of the examples provided in the first aspect of the present disclosure.

The method includes: providing a first substrate and a second substrate; and fabricating the driving chip on the first substrate, and simultaneously fabricating the bidirectional power device on the second substrate.

The present disclosure provides a technical solution in which the driving chip includes a driving circuit and a substrate potential modulation circuit. The substrate potential modulation circuit receives signals from the control end and from the first power end and/or the second power end of the bidirectional power device, and is connected to the substrate potential end of the bidirectional power device, such that the voltage at the substrate potential end of the bidirectional power device is substantially consistent with a lowest voltage among the voltages at the control end, the first power end, and the second power end, thereby avoiding the impact of substrate floating on the performance and reliability of the bidirectional power device.

The present disclosure integrates the substrate potential modulation circuit into the driving chip of the bidirectional power device. This not only avoids increasing the cost and parasitic parameters of the bidirectional power device, but also allows the substrate potential modulation circuit to be designed according to actual requirements, thereby better achieving management of the substrate potential of the bidirectional power device.

Furthermore, by integrating the substrate potential modulation circuit and the driving circuit of the bidirectional power device into the same chip, the substrate potential modulation circuit can be fabricated simultaneously with the driving circuit, which reduces manufacturing steps, improves production efficiency, eliminates the cost of independently fabricating the substrate potential modulation circuit, and thereby lowers the overall manufacturing cost of the power conversion apparatus.

### BRIEF DESCRIPTION OF DRAWINGS

The figures herein are incorporated into the specification and form a part of the specification. They illustrate embodiments consistent with the present disclosure and, together with the specification, are used to explain the principles of the present disclosure.
FIG. 1 is a circuit diagram of a driving chip according to an embodiment of the present disclosure;
FIG. 2 is a first circuit diagram of a substrate potential modulation circuit of a bidirectional power device integrated in the driving chip, according to an embodiment of the present disclosure;
FIG. 3 is a second circuit diagram of a substrate potential modulation circuit of a bidirectional power device integrated in the driving chip, according to an embodiment of the present disclosure;
FIG. 4 is a schematic diagram of a substrate structure of the driving chip according to an embodiment of the present disclosure;
FIG. 5 is a schematic cross-sectional diagram of an intermediate structure obtained after simultaneously forming a first well region and/or a second well region, and simultaneously forming a third well region and a fourth well region in the substrate, according to an embodiment of the present disclosure;
FIG. 6a is a first schematic cross-sectional diagram of an intermediate structure obtained after simultaneously forming corresponding source/drain regions in different well regions, according to an embodiment of the present disclosure;
FIG. 6b is a second schematic cross-sectional diagram of an intermediate structure obtained after simultaneously forming corresponding source/drain regions in different well regions, according to an embodiment of the present disclosure;
FIG. 7a is a first schematic cross-sectional diagram of an intermediate structure obtained after forming a dielectric layer on an upper surface of the substrate, according to an embodiment of the present disclosure;
FIG. 7b is a second schematic cross-sectional diagram of an intermediate structure obtained after forming a dielectric layer on an upper surface of the substrate, according to an embodiment of the present disclosure;
FIG. 8a is a first schematic cross-sectional diagram of an intermediate structure obtained after respectively and simultaneously forming a first gate and/or a second gate, a third gate, and a fourth gate on an upper surface of the substrate, according to an embodiment of the present disclosure;
FIG. 8b is a second schematic cross-sectional diagram of an intermediate structure obtained after respectively and simultaneously forming a first gate and/or a second gate, a third gate, and a fourth gate on an upper surface of the substrate, according to an embodiment of the present disclosure;
FIG. 9a is a first schematic cross-sectional diagram of an intermediate structure obtained after respectively forming a first metal electrode, a second metal electrode, a third metal electrode, and a fourth metal electrode, according to an embodiment of the present disclosure;
FIG. 9b is a second schematic cross-sectional diagram of an intermediate structure obtained after respectively forming a first metal electrode, a second metal electrode, a third metal electrode, and a fourth metal electrode, according to an embodiment of the present disclosure;
FIG. 10 is a first schematic diagram of a structure obtained after fabricating a driving chip on a first substrate and simultaneously fabricating a bidirectional power device on a second substrate, according to an embodiment of the present disclosure;
FIG. 11 is a second schematic diagram of a structure obtained after fabricating a driving chip on a first substrate and simultaneously fabricating a bidirectional power device on a second substrate, according to an embodiment of the present disclosure;
FIG. 12 is a third schematic diagram of a structure obtained after fabricating a driving chip on a first substrate and simultaneously fabricating a bidirectional power device on a second substrate, according to an embodiment of the present disclosure; and
FIG. 13 is a fourth schematic diagram of a structure obtained after fabricating a driving chip on a first substrate and simultaneously fabricating a bidirectional power device on a second substrate, according to an embodiment of the present disclosure.

Through the above figures, clear embodiments of the present disclosure are shown, and more detailed descriptions will be provided in the following text. These figures and the written description are not intended to restrict the scope of the inventive concept of the present disclosure in any way, but rather to illustrate the concepts of the present disclosure to those skilled in the art by reference to specific embodiments.

### DETAILED DESCRIPTION OF THE INVENTION

The present disclosure will now be described in detail with reference to exemplary embodiments, which are illustrated in the accompanying figures. In the following description, unless otherwise indicated, identical numbers in different figures represent the same or similar elements. The embodiments described in the following exemplary embodiments do not represent all embodiments consistent with the present disclosure. Rather, they are merely examples of apparatuses and methods consistent with certain aspects of the present disclosure.

Unless otherwise defined, all technical and scientific terms used herein have the same meaning as commonly understood by those skilled in the art to which the present disclosure pertains. The terminology used in the specification of the present disclosure is solely for the purpose of describing particular embodiments and is not intended to restrict the present disclosure. It should be understood that the terms "first," "second," and the like as used in the present disclosure may be employed to describe various information or data, but such elements are not limited by these terms. These terms are only used to distinguish one piece of information from another. For example, without departing from the scope of the present disclosure, first action information may be referred to as second action information, and similarly, second action information may be referred to as first action information. Both first action information and second action information are action information, but they are not the same action information.

As requirements for the size and energy efficiency of power devices increase, wide-bandgap semiconductor GaN devices, due to their lower power loss and faster switching capability, have been widely used in power conversion apparatuses.

In some applications requiring bidirectional switching, GaN HEMT devices can be equivalently regarded as two transistors coupled in a back-to-back series configuration. Compared with the series connection of two Si-based transistors, Bi-GaN HEMT devices have lower power consumption and a more compact size.

However, during the switching process, if the substrate of the Bi-GaN HEMT is floating, charges will accumulate in the substrate during device switching, which adversely affects the switching performance and causes degradation of dynamic resistance. In conventional GaN HEMT devices, in order to avoid the impact of substrate floating on device performance and reliability, the substrate is typically maintained at the same potential as the source. But in bidirectional GaN HEMT devices, since the source and drain switch according to the operating state of the circuit, the substrate cannot be directly electrically connected to either the source or the drain.

At present, most approaches adopt additional manufacturing processes to implant potential management structures inside the Bi-GaN HEMT to achieve regulation of the substrate potential. However, such clamping circuits not only introduce additional parasitic capacitance, which affects device efficiency, but also increase the overall cost of GaN power devices.

To address the above issues, the present disclosure provides a driving chip that integrates a substrate potential modulation circuit (also referred to as potential modulation circuit) and a driving circuit of a bidirectional power device into the same chip. Without increasing the cost and parasitic parameters of the bidirectional power device itself, the structure of the potential modulation circuit can be adjusted according to actual applications, thereby better achieving control of the substrate potential.

Below, specific embodiments are provided to describe the technical solution of the present disclosure in detail and how the technical solution addresses the above technical problems. The following specific embodiments may be combined with each other, and for the same or similar concepts or processes, detailed descriptions may be omitted in some embodiments. The embodiments of the present disclosure will be described with reference to the accompanying figures.

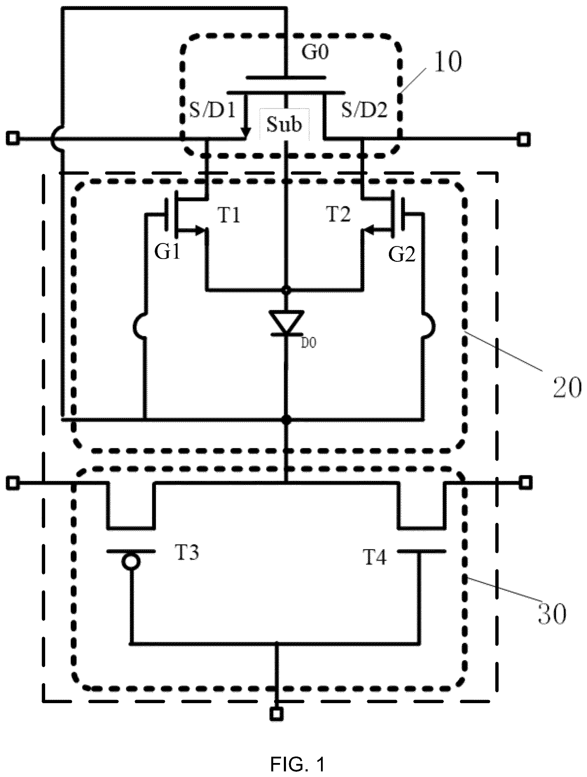

In a first aspect, referring to FIG. 1, a driving chip provided in an embodiment of the present disclosure is shown, where the driving chip includes a driving circuit 30 and a substrate potential modulation circuit 20. The driving circuit is configured to drive a bidirectional power device 10, and the substrate potential modulation circuit 20 is configured to modulate a substrate potential of the bidirectional power device.

The bidirectional power device is a class of power electronic devices capable of conducting current in two directions and controlling current flow. The bidirectional power device may include, for example, bidirectional metal-oxide-semiconductor field-effect transistors (MOSFETs), bidirectional insulated gate bipolar transistors (IGBTs), or bidirectional SiC/GaN devices.

Optionally, in the embodiments of the present disclosure, the bidirectional power device 10 may be a bidirectional GaN device. It should be understood that the bidirectional power device 10 may also be other suitable bidirectional power devices, and the embodiments of the present disclosure are not particularly limited in this regard.

Optionally, the driving circuit 30 and the substrate potential modulation circuit 20 are formed in the same substrate, such that the potential modulation circuit can be fabricated concurrently when fabricating the driving circuit, which reduces manufacturing steps, thereby improving production efficiency, reduces the cost of independently fabricating the potential modulation circuit, and in turn lowers the overall manufacturing cost of the power conversion apparatus.

In some examples, referring to FIG. 1, the bidirectional power device 10 includes a control end G0, a first power end S/D1, a second power end S/D2, and a substrate potential end Sub. The driving circuit 30 is connected to the control end G0 and is configured to drive the bidirectional power device 10. The substrate potential modulation circuit 20 is configured to receive signals from the control end G0 and from the first power end S/D1 and/or the second power end S/D2, and is connected to the substrate potential end Sub, such that a voltage of the substrate potential end Sub of the bidirectional power device is substantially consistent with a lowest voltage among voltages at the control end G0, the first power end S/D1, and the second power end S/D2.

Based on this, the substrate potential modulation circuit in the driving chip provided in embodiments of the present disclosure can maintain the voltage at the substrate potential end Sub of the bidirectional power device substantially consistent with the lowest voltage among the voltages at the control end G0, the first power end S/D1, and the second power end S/D2, thereby avoiding the impact of substrate floating on the performance and reliability of the bidirectional power device.

In embodiments of the present disclosure, the potential modulation circuit is integrated into the driving chip of the bidirectional power device. This not only avoids increasing the cost and parasitic parameters of the bidirectional power device, but also allows the potential modulation circuit to be designed according to actual requirements, thereby better achieving management of the substrate potential of the bidirectional power device.

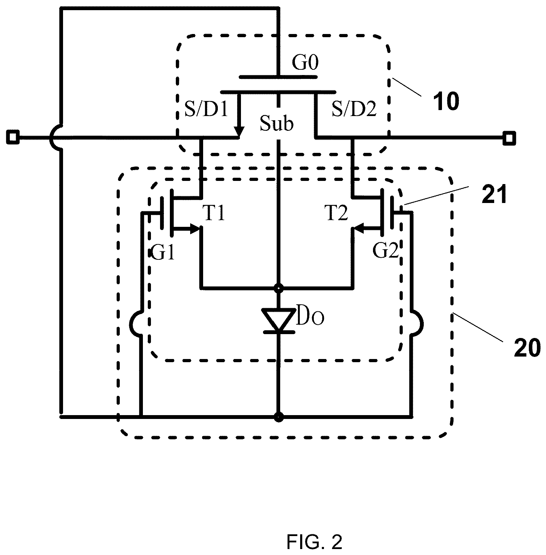

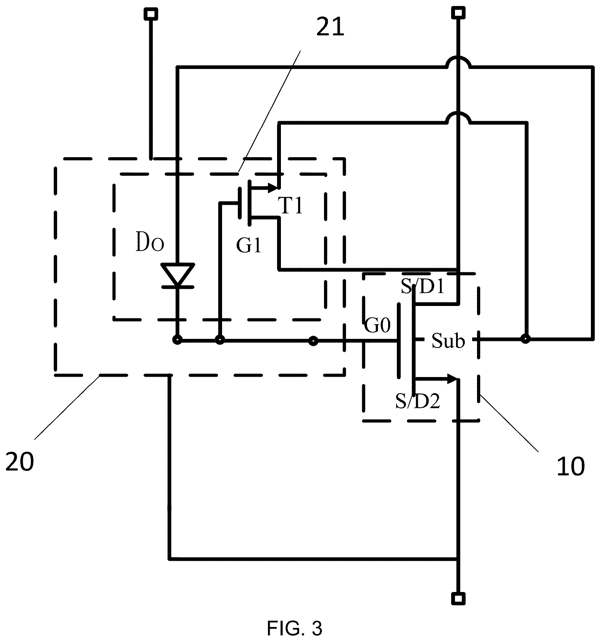

Referring to FIGs. 2 and 3, the potential modulation circuit 20 includes a switching module 21.

A first end of the switching module 21 is electrically connected to whichever of the first power end S/D1 or the second power end S/D2 has the lower voltage, a second end of the switching module 21 is electrically connected to the substrate potential end Sub of the bidirectional power device 10, and a control end of the switching module 21 is electrically connected to the control end G0 of the bidirectional power device. The switching module 21 is configured, when the bidirectional power device 10 is conducting, to connect the substrate potential end Sub to whichever of the first power end S/D1 or the second power end S/D2 has the lower potential, so that the substrate potential end Sub remains at the lower potential of the bidirectional power device 10. In the turn-off state of the bidirectional power device, by connecting a diode D0 to the control end G0, the substrate potential end Sub is thereby maintained at the lower potential of the bidirectional power device 10.

It should be noted that the first power end S/D1 may be one of the source and the drain of the bidirectional power device, and the second power end S/D2 may be the other one of the source and the drain.

In embodiments of the present disclosure, an input end (i.e., first end) of the switching module 21 is connected to the first power end S/D1 and the second power end S/D2 of the bidirectional power device 10, and an output end (i.e., second end) of the switching module 21 is connected to the substrate potential end Sub of the bidirectional power device 10. The switching module 21 is configured to modulate the substrate potential end Sub according to the lower potential of the first power end S/D1 and the second power end S/D2, so that the substrate potential end Sub remains at the lower potential, thereby avoiding the impact of substrate floating on the performance and reliability of the bidirectional power device 10.

Specifically, maintaining the substrate potential end Sub at the lower potential of the first power end S/D1 and the second power end S/D2 not only reduces thermal effects caused by parasitic effects, improves thermal stability, reliability, and anti-interference capability, and reduces the impact of external noise on device performance, but also lowers the on-resistance of the bidirectional power device 10, improves conduction efficiency, reduces switching losses, increases switching speed, and thereby enhances the overall performance of the bidirectional power device 10.

Furthermore, by integrating the potential modulation circuit into the driving chip where the driving circuit 30 of the bidirectional power device 10 is located, the potential modulation circuit 20 can be fabricated simultaneously with the driving circuit 30, which reduces manufacturing steps and process complexity, improves production efficiency, eliminates the cost of independently fabricating the potential modulation circuit, and lowers overall manufacturing cost.

Optionally, when designing the driving chip, the potential modulation circuit of the bidirectional power device 10 may be designed as a sub-module to ensure its functionality and performance meet requirements. During manufacturing, unified doping and epitaxial growth processes may be used to fabricate the driving circuit 30 and the potential modulation circuit 20 simultaneously. Through lithography and etching processes, the structures of the potential modulation circuit 20 and the driving circuit 30 are formed on the same chip. During metallization and packaging, the connection points of the potential modulation circuit 20 and the driving circuit 30 are metallized and packaged.

The above content describes the overall structure and effect of the switching module 21 in detail. The following content describes the specific structure and principle of the switching module 21 through several embodiments.

In one optional embodiment, referring to FIG. 2, the switching module 21 includes a first transistor T1 and a second transistor T2.

A first end of the first transistor T1 is electrically connected to one of the first power end S/D1 or the second power end S/D2 of the bidirectional power device 10, a second end of the first transistor T1 is electrically connected to the substrate potential end Sub of the bidirectional power device 10, and a control end G1 of the first transistor T1 is electrically connected to the control end G0 of the bidirectional power device. A first end of the second transistor T2 is electrically connected to the other of the first power end S/D1 or the second power end S/D2 of the bidirectional power device, a second end of the second transistor T2 is electrically connected to the substrate potential end Sub of the bidirectional power device 10, and a control end G2 of the second transistor T2 is electrically connected to the control end G0 of the bidirectional power device.

For example, when the first end of the first transistor T1 is electrically connected to the first power end S/D1 of the bidirectional power device, the first end of the second transistor T2 is electrically connected to the second power end S/D2.

When the bidirectional power device 10 is conducting and the voltage of the first power end S/D1 is lower than the voltage of the second power end S/D2, the first transistor T1 conducts, connecting the first power end S/D1 of the bidirectional power device 10 to the substrate potential end Sub.

When the control signal is configured as a conduction signal, the bidirectional power device 10 conducts, and T1 and T2 also conduct. When the voltage of the second power end S/D2 is lower than the voltage of the first power end S/D1, current flows from the first power end S/D1 to the second power end S/D2, and the voltage of the substrate potential end Sub is between the potentials of S/D1 and S/D2.

It should be understood that the voltage difference between the first power end S/D1 and the second power end S/D2 of the bidirectional power device 10 is small, so the substrate potential end Sub can remain at a lower potential.

In one embodiment, when the control signal applied to the control end G0 of the bidirectional power device 10 is a conduction signal, the first transistor T1 and the second transistor T2 simultaneously respond to the control signal. Based on this, synchronous control of the bidirectional power device 10, the first transistor T1, and the second transistor T2 can be achieved, simplifying control logic, reducing signal transmission delay, and improving response speed.

Exemplarily, the first transistor T1 and the second transistor T2 may be implemented using one of a bipolar junction transistor (BJT), a metal-oxide-semiconductor field-effect transistor (MOSFET), an insulated gate bipolar transistor (IGBT), or a junction field-effect transistor (JFET). The embodiments of the present disclosure are not particularly limited in this regard.

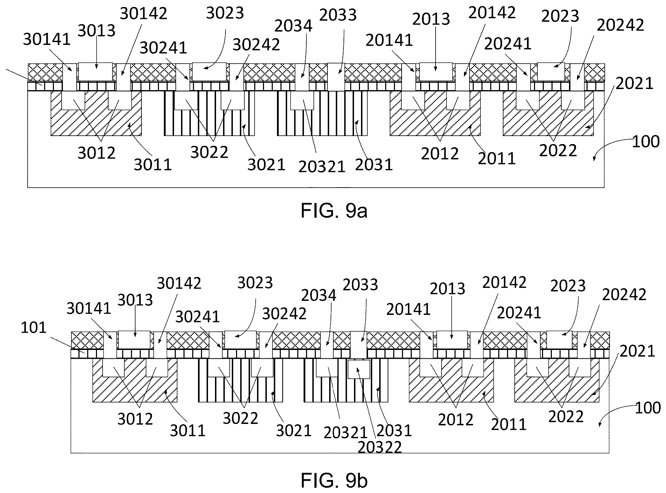

In one optional embodiment, referring to FIG. 9b, the first transistor includes a first well region 2011 of a first doping type located in the substrate, first source/drain regions 2012 of a second doping type located in the first well region 2011, and a first gate 2013 disposed between the first source/drain regions 2012. The first gate 2013 is the control end of the first transistor, and a first end 20141 and a second end 20142 of the first transistor are formed on the upper surfaces of the first source/drain regions 2012.

Referring to FIG. 9b, the second transistor includes a second well region 2021 of the first doping type located in the substrate, second source/drain regions 2022 of the second doping type located in the second well region 2021, and a second gate 2023 disposed on the upper surface of the substrate and between the second source/drain regions 2022. The second gate 2023 serves as the control end of the second transistor, and a first end 20241 and a second end 20242 of the second transistor are formed on the upper surfaces of the second source/drain regions 2022.

The control end G1 of the first transistor T1 and the control end G2 of the second transistor T2 are both connected to the control end G0 of the bidirectional power device 10.

That is, when a control signal is applied to the control end G0 of the bidirectional power device 10, the first transistor T1 and the second transistor T2 simultaneously respond to the control signal. Based on this, synchronous control of the bidirectional power device 10, the first transistor T1, and the second transistor T2 can be achieved, the control logic is simplified, the signal transmission delay is reduced, and the response speed is improved.

Exemplarily, when the bidirectional power device 10 and the first and second transistors T1 and T2 are of the same type of device, the control signal can synchronously control the bidirectional power device 10, the first transistor T1, and the second transistor T2 to turn on or off. That is, when the bidirectional power device 10 is in a conducting state, the first transistor T1 and the second transistor T2 are synchronously in a conducting state. At this time, if the potential of the first power end S/D1 is lower, current flows from S/D2 to S/D1, and the substrate potential is between S/D2 and S/D1, approximately equal to the potential of S/D1. If the potential of the second power end S/D2 is lower, current flows from S/D1 to S/D2, and the substrate potential is between S/D2 and S/D1, approximately equal to the potential of S/D2. It should be understood that when the bidirectional power device 10 is conducting state, the voltage difference between the first power end S/D1 and the second power end S/D2 is small. Therefore, regardless of whether the voltage of the first power end S/D1 is greater or less than the voltage of the second power end S/D2, the substrate potential end Sub can always be maintained at a lower potential.

In another optional embodiment, referring to FIG. 3, the switching module 21 includes only the first transistor T1. A first end of the first transistor T1 is connected to the first power end S/D1 of the bidirectional power device 10, and a second end of the first transistor T1 is connected to the substrate potential end Sub of the bidirectional power device 10.

Further, the control end G0 of the bidirectional power device 10 is connected to the control end G1 of the first transistor T1.

When the bidirectional power device 10 conducts, the voltage of the first power end S/D1 is substantially equal to the voltage of the second power end S/D2. Since the first transistor T1 is also conducting, the first power end S/D1 of the bidirectional power device 10 is connected to the substrate potential end Sub of the bidirectional power device 10 through the first transistor T1, such that the voltage at the substrate potential end Sub equals the voltage at the first power end S/D1, which is also the voltage at the second power end S/D2. It should be understood that even if there is a voltage difference between S/D1 and S/D2, since the bidirectional power device 10 conducts, the voltage difference is small. Therefore, whether the first transistor T1 is connected to the first power end S/D1 or to the second power end S/D2, the substrate potential remains at a lower potential.

When the bidirectional power device 10 is in a turn-off state, the substrate potential end Sub is connected through a diode to the control end G0 of the bidirectional power device 10. It should be understood that when the bidirectional power device 10 is in a turn-off state, the voltage at the control end G0 is zero or a negative voltage. Therefore, at this time, the substrate potential end Sub equals zero or a negative voltage, ensuring that the substrate potential end Sub remains at a lower potential.

Based on the above description, the substrate potential end Sub of the bidirectional power device 10 can be maintained at the lower potential among the voltages at the control end G0, the first power end S/D1, and the second power end S/D2.

It should be understood that since the control end G1 of the first transistor T1 is connected to the control end G0 of the bidirectional power device 10, when a control signal is applied to the control end G0, the first transistor T1 simultaneously responds to the control signal. Based on this, synchronous control of the bidirectional power device 10 and the first transistor T1 can be achieved, simplifying control logic, reducing signal transmission delay, and improving response speed.

The above content provides a detailed description of the specific structure and operating principle of the switching module 21. Based on this, the substrate potential end Sub of the bidirectional power device 10 can be maintained at a lower potential, thereby achieving control of the substrate potential end Sub without increasing the cost or parasitic parameters of the bidirectional power device 10 itself.

In embodiments of the present disclosure, referring to FIG. 2, the switching module further includes a diode D0. The cathode of the diode D0 is electrically connected to the control end of the first transistor T1 and the control end of the second transistor T2, and the anode of the diode D0 is electrically connected to the substrate potential end Sub of the bidirectional power device.

In embodiments of the present disclosure, referring to FIG. 3, the switching module further includes a diode D0. The cathode of the diode D0 is electrically connected to the control end of the first transistor T1, and the anode of the diode D0 is electrically connected to the substrate potential end Sub of the bidirectional power device.

When the control signal is a turn-off signal, the first transistor T1 and the second transistor T2 are in an off state, and the voltage at the substrate potential end Sub is coupled through the diode D0 to the control signal. Since the potential of the control signal is low, the substrate potential end Sub of the bidirectional power device 10 can be maintained at a lower potential.

Exemplarily, the diode may be a PN junction diode or a Schottky diode. It should be understood that the diode D0 may also be any other component having similar functionality, and the embodiments of the present disclosure are not particularly limited in this regard.

In an optional embodiment, referring to FIG. 1, the driving circuit 30 includes a third transistor T3 and a fourth transistor T4.

A second end of the third transistor T3 is electrically connected to a first end of the fourth transistor T4, and is also electrically connected to the substrate potential end Sub and the control end G0 of the bidirectional power device 10, so as to drive the bidirectional power device 10. A control end of the third transistor T3 is electrically connected to a control end of the fourth transistor T4.

The second end (source or drain) of the third transistor T3 is electrically connected to the first end (drain or source) of the fourth transistor T4, thereby forming an output path to drive the bidirectional power device.

The control end of the third transistor T3 is electrically connected to the control end of the fourth transistor T4, which indicates that the control end of the third transistor T3 and the control end of the fourth transistor T4 are synchronously controlled, i.e., they will turn-on or turn-off simultaneously. This synchronous control ensures the stability and reliability of the driving circuit.

Based on this, the present disclosure can control the turn-on or turn-off state of the bidirectional power device through the driving circuit.

In a second aspect, embodiments of the present disclosure further provide a bidirectional power apparatus. The bidirectional power apparatus includes a driving chip and a bidirectional power device. The driving chip is configured to drive the bidirectional power device and to modulate a substrate potential of the bidirectional power device.

The driving chip is configured to control the bidirectional power device to be conducting or non-conducting, and to modulate the substrate potential of the bidirectional power device when the bidirectional power device is conducting or non-conducting, such that the voltage at the substrate potential end of the bidirectional power device is substantially consistent with a lowest voltage among the voltages at the control end, the first power end, and the second power end, thereby avoiding the impact of substrate floating on the performance and reliability of the bidirectional power device.

It should be understood that the beneficial effects of the bidirectional power apparatus provided in the present disclosure are the same as those of the driving chip described in the embodiments shown in FIGs. 1 to 3, and therefore are not repeated here.

In a third aspect, the present disclosure further provides a method for manufacturing a driving chip. The method includes steps A1 and A2.

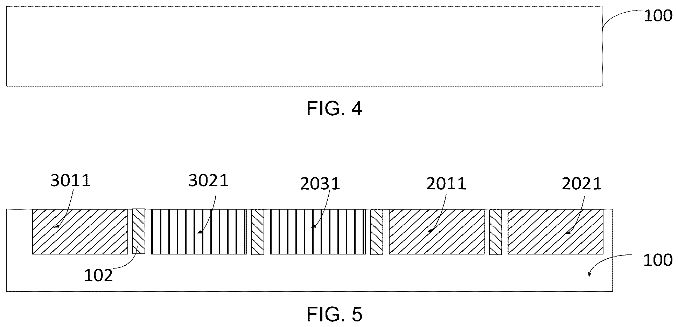

Referring to FIG. 4, step A1 includes providing a substrate 100. The substrate may be a silicon substrate.

It should be understood that the substrate serves as the foundation of the driving chip, carrying the structure of the driving chip. The substrate provides the planar or three-dimensional structure required for manufacturing the driving chip, enabling other functional layers (such as epitaxial layers and doped regions) to be orderly formed in or grown on the substrate.

Referring to FIGs. 5 to 9b, step A2 includes forming a driving circuit 30 and a substrate potential modulation circuit 20 in the substrate 100. The driving circuit is configured to drive a bidirectional power device, and the substrate potential modulation circuit is configured to modulate a substrate potential of the bidirectional power device.

The bidirectional power device includes a first power end, a second power end, a control end, and a substrate potential end. The substrate potential modulation circuit is configured to receive signals from the control end and from the first power end and/or the second power end, and is connected to the substrate potential end, such that the voltage at the substrate potential end of the bidirectional power device is substantially consistent with a lowest voltage among the voltages at the control end, the first power end, and the second power end.

Based on this, the driving chip provided in embodiments of the present disclosure includes the driving circuit and the substrate potential modulation circuit integrated in the same chip. The substrate potential modulation circuit is configured to receive signals from the control end, the first power end and/or the second power end of the bidirectional power device, and is connected to the substrate potential end of the bidirectional power device, such that the voltage at the substrate potential end is substantially consistent with the lowest voltage among the voltages at the control end, the first power end, and the second power end, thereby avoiding the impact of substrate floating on the performance and reliability of the bidirectional power device.

In embodiments of the present disclosure, the substrate potential modulation circuit and the driving circuit are integrated in the driving chip. This not only avoids increasing the cost and parasitic parameters of the bidirectional power device, but also allows the potential modulation circuit to be designed according to actual requirements, thereby better achieving management of the substrate potential of the bidirectional power device.

Furthermore, by integrating the substrate potential modulation circuit and the driving circuit of the bidirectional power device into the same chip, the substrate potential modulation circuit can be fabricated simultaneously with the driving circuit, reducing manufacturing steps, improving production efficiency, eliminating the cost of independently fabricating the potential modulation circuit, and thereby lowering the overall manufacturing cost of the power conversion apparatus.

As an optional embodiment, the substrate potential modulation circuit includes a first transistor and/or a second transistor; the driving circuit includes a third transistor and a fourth transistor.

The step of forming the driving circuit and the substrate potential modulation circuit in the substrate includes steps A21 to A23.

Referring to FIG. 5, step A21 includes forming a first well region 2011 and/or a second well region 2021, and forming a third well region 3011 and a fourth well region 3021 in the substrate 100.

Based on this, manufacturing steps of the driving chip can be reduced, thereby improving production efficiency, lowering manufacturing cost, and shortening the production cycle.

Optionally, the first well region 2011 and the second well region 2021 include dopant ions of the same type; the third well region 3011 and the fourth well region 3021 include dopant ions of opposite types.

In some examples, the first well region 2011, the second well region 2021, and the third well region 3011 include dopant ions of the same type, and can be formed simultaneously, thereby reducing process steps and improving manufacturing efficiency.

It should be understood that through the above doping strategy, the first transistor, the second transistor, the third transistor, and the fourth transistor having different functions and characteristics can be realized on the same driving chip, thereby meeting application requirements of the driving chip.

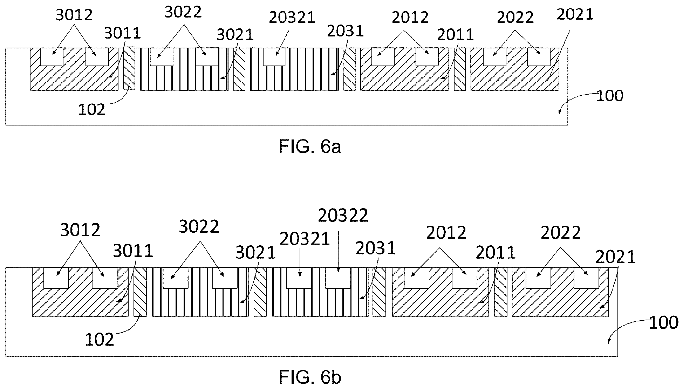

Referring to FIGs. 6a and 6b, step A22 includes respectively and simultaneously forming the first source/drain regions 2012 in the first well region 2011 and/or the second source/drain regions 2022 in the second well region 2021, the third source/drain regions 3012 in the third well region 3011, and the fourth source/drain regions 3022 in the fourth well region 3021.

The first source/drain regions 2012 and the first well region 2011 include dopant ions of opposite types and the second source/drain regions 2022 and the second well region 2021 include dopant ions of opposite types; the third source/drain regions 3012 and the third well region 3011 include dopant ions of opposite types; and the fourth source/drain regions 3022 and the fourth well region 3021 include dopant ions of opposite types.

Through this step, corresponding source/drain regions can be simultaneously formed in different well regions, thereby improving manufacturing efficiency.

Specifically, forming the first source/drain regions 2012 in the first well region 2011 and forming the second source/drain regions 2022 in the second well region 2021 enables realization of transistors of the same type (such as multiple NMOS or PMOS transistors) on the same driving chip. Specifically, forming the third source/drain regions 3012 in the third well region 3011 and forming the fourth source/drain regions 3022 in the fourth well region 3021 enables realization of transistors of different types (such as NMOS and PMOS) on the same driving chip.

The respective well regions provide electrical isolation between different transistors, thereby reducing interference among the transistors.

Optionally, the substrate potential modulation circuit further includes a diode.

In this case, referring to FIG. 5, the method further includes forming a fifth well region 2031 in the substrate.

The dopant ion type of the fifth well region 2031 is the same as that of the fourth well region 3021. Based on this, the fifth well region 2031 can be formed in the substrate simultaneously with the formation of the fourth well region, thereby reducing process steps in manufacturing the driving chip and improving process efficiency.

It should be understood that the embodiments of the present disclosure do not restrict the formation sequence of the first well region 2011, the second well region 2021, the third well region 3011, the fourth well region 3021, and the fifth well region 2031.

Referring to FIGs. 6a and 6b, while respectively and simultaneously forming the first source/drain regions in the first well region, the second source/drain regions in the second well region, the third source/drain regions in the third well region, and the fourth source/drain regions in the fourth well region, the method further includes: forming a first doped region 20321 and/or a second doped region 20322 in the fifth well region 2031.

In embodiments of the present disclosure, by forming the first doped region 20321 and/or the second doped region 20322 in the fifth well region, the chip area can be better utilized, achieving higher integration and performance.

In some examples, the first doped region 20321 and the second doped region 20322 are used as functional regions for subsequently forming a diode.

The dopant ion types of the first doped region 20321 and the second doped region 20322 are opposite.

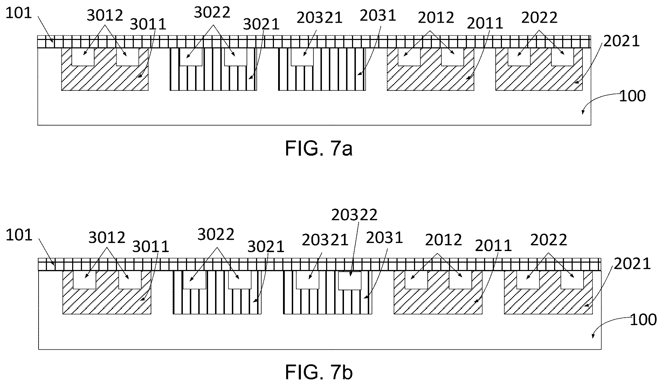

Based on this, when two adjacent regions have opposite doping types (one n-type and the other p-type), a PN junction is formed between them. This PN junction can form a PN junction diode, for example between the first doped region 20321 and the second doped region 20322 as shown in FIGs. 6b and 7b.

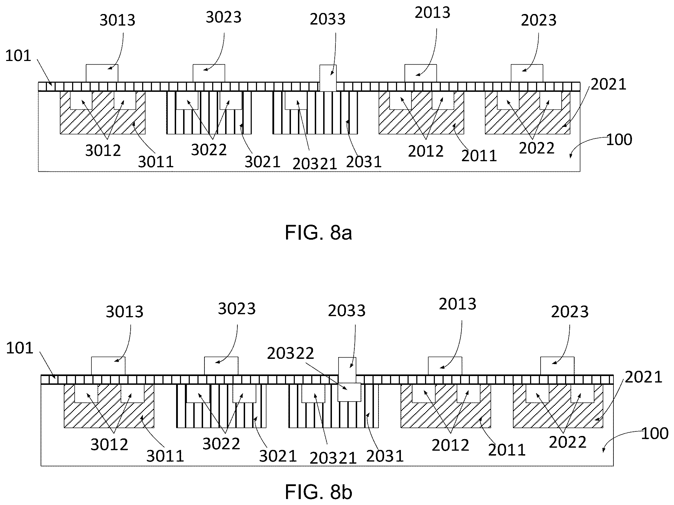

Referring to FIGs. 8a and 8b, step A23 includes respectively and simultaneously forming a first gate 2013 and/or a second gate 2023, a third gate 3013, and a fourth gate 3023 on the upper surface of the substrate 100. The first gate 2013 serves as the control end of the first transistor, the second gate 2023 serves as the control end of the second transistor, the third gate 3013 serves as the control end of the third transistor, and the fourth gate 3023 serves as the control end of the fourth transistor.

It should be understood that by completing the formation of multiple gates in the same process step, the number of process steps can be reduced, thereby lowering cost and shortening production time. Moreover, by forming multiple gates on the same substrate, multiple circuit functions and application requirements can be supported.

In some examples, referring to FIGs. 7a and 7b, after the above step A22, the manufacturing method may further include: forming a dielectric layer 101 on the upper surface of the substrate 100.

In embodiments of the present disclosure, the dielectric material of the dielectric layer 101 includes silicon dioxide (*SiO*₂), silicon nitride (*Si*₃*N*₄), or other low-dielectric-constant materials. The choice of material depends on the required electrical, mechanical, and thermal properties.

Optionally, the dielectric layer 101 is used to isolate the source/drain regions and the corresponding gates.

Subsequently, referring to FIGs. 8a and 8b, step A23 includes: respectively and simultaneously forming the first gate 2013 and/or the second gate 2023, the third gate 3013, and the fourth gate 3023 on the upper surface of the dielectric layer 101.

The dielectric layer 101 helps reduce interference and crosstalk between different gates and source/drain regions, thereby ensuring signal integrity.

In some optional embodiments, the manufacturing method provided in the present disclosure may further include step A24.

Referring to FIGs. 9a and 9b, step A24 includes respectively and simultaneously forming, on the upper surfaces of the first source/drain regions and/or the second source/drain regions, the third source/drain regions, and the fourth source/drain regions, first metal electrodes (20141 and 20142), second metal electrodes (20241 and 20242), third metal electrodes (30141 and 30142), and fourth metal electrodes (30241 and 30242) penetrating the dielectric layer.

The first metal electrodes (20141 and 20142) are located on two sides of the first gate 2013 and electrically connected to the first source/drain regions 2012; and/or the second metal electrodes (20241 and 20242) are located on two sides of the second gate 2023 and electrically connected to the second source/drain regions 2022; and the third metal electrodes (30141 and 30142) are located on two sides of the third gate 3013 and electrically connected to the third source/drain regions 3012; and the fourth metal electrodes (30241 and 30242) are located on two sides of the fourth gate 3023 and electrically connected to the fourth source/drain regions 3022.

Optionally, the above metal electrodes provide electrical connection between the corresponding source/drain regions and external circuits. By forming metal electrodes penetrating the dielectric layer, current can be effectively transmitted from the source/drain regions to external circuits.

Optionally, while performing step A24, the manufacturing method provided in the present disclosure may further include: forming, on the upper surface of the fifth well region 2031, an anode metal electrode (one of 2033 and 2034) and a cathode metal electrode (the other of 2033 and 2034) penetrating the dielectric layer.

As shown in FIG. 9b, the cathode metal electrode is formed on the upper surface of the first doped region 20321 and electrically connected to first doped region 20321; and/or the anode metal electrode is formed on the upper surface of the second doped region 20322 and electrically connected to the second doped region 20322, thereby forming a PN diode.

As shown in FIG. 9a, the first doped region 20321 contacts the cathode metal electrode 2034, and the anode metal electrode 2033 contacts the upper surface of the fifth well region 2031, thereby forming a Schottky diode.

In embodiments of the present disclosure, the anode and cathode metal electrodes provide electrical connection to external circuits. By forming anode and cathode metal electrodes penetrating the dielectric layer, current can be effectively transmitted from the first and second doped regions to external circuits.

Moreover, the above operation can reduce the number of process steps, thereby lowering cost and shortening production time.

In some possible implementations, referring to FIG. 5, after forming the first well region and/or the second well region in the substrate, and forming the third well region and the fourth well region in the substrate, the method further includes: simultaneously forming isolation regions 102 between two adjacent well regions among the first well region 2011 and/or the second well region 2021, the third well region 3011, and the fourth well region 3021.

Based on this, the isolation regions 102 can be used to prevent current leakage between adjacent well regions, ensuring that devices within each well region can operate independently without being affected by adjacent regions.

The isolation regions may be implemented by shallow trench isolation (STI) or deep trench isolation (DTI) technology.

Through the above steps, the manufacturing of the driving chip is achieved. Thereafter, the functional regions may be electrically connected in the following manner.

One of the first metal electrodes on the source or drain of the first source/drain regions is grounded and electrically connected to one of the first power end and the second power end of the bidirectional power device. The other one of the first metal electrodes is connected to the anode metal electrode on the fifth well region and further connected to the substrate potential end of the bidirectional power device. One of the second metal electrodes on the source or drain of the second source/drain regions is electrically connected to the other of the first power end and the second power end of the bidirectional power device. The other one of the second metal electrodes is connected to the anode metal electrode on the fifth well region and further connected to the substrate potential end of the bidirectional power device. The first gate and the second gate are electrically connected together and connected to the control end of the bidirectional power device. The control end of the bidirectional power device is further electrically connected to the cathode metal electrode on the fifth well region. The third metal electrodes on the third source/drain regions are connected to the cathode metal electrode on the fifth well region. The fourth metal electrodes on the fourth source/drain regions are connected to the cathode metal electrode on the fifth well region. The third gate and the fourth gate are electrically connected together and connected to the same control voltage end.

The cathode metal electrode on the fifth well region is electrically connected to the control end of the bidirectional power device. The anode metal electrode on the fifth well region is electrically connected to the substrate potential end of the bidirectional power device.

Based on this, the method for manufacturing the driving chip is provided. The driving circuit of the bidirectional power device and the substrate potential modulation circuit are integrated in the same chip. By fabricating the substrate potential modulation circuit simultaneously with the driving circuit, manufacturing steps can be reduced, thereby improving production efficiency, eliminating the cost of independently fabricating the potential modulation circuit, and further lowering the overall manufacturing cost of the power conversion apparatus.

In a fourth aspect, embodiments of the present disclosure further provide a method for manufacturing a bidirectional power apparatus. The bidirectional power apparatus includes the driving chip as described in the first aspect of the present disclosure and a bidirectional power device.

The method includes: providing a first substrate 100 and a second substrate 200. The substrate of the driving chip is a silicon (Si) substrate.

The second substrate may be a Si substrate, a sapphire substrate, a SiC substrate, or the like.

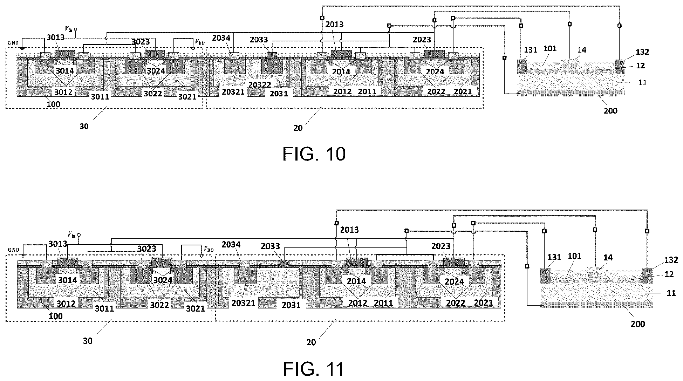

Referring to FIG. 10, the driving chip is fabricated on the first substrate, and simultaneously the bidirectional power device is fabricated on the second substrate.

The step of fabricating the bidirectional power device on the second substrate may include:
forming a buffer layer 11 (e.g., GaN layer) on the second substrate 200;
forming a barrier layer 12 (e.g., AlGaN) on the buffer layer 11; and
forming a dielectric layer 101 on an upper surface of the barrier layer 12.

Optionally, after forming the dielectric layer on the upper surface of the second substrate, the method further includes: forming a fifth metal electrode 131, a sixth metal electrode 132, and a control electrode 14. The fifth metal electrode serves as the first power end of the bidirectional power device, the sixth metal electrode serves as the second power end of the bidirectional power device, and the control electrode serves as the control end of the bidirectional power device.

Based on this, the manufacturing of the bidirectional power apparatus is achieved. Thereafter, the bidirectional power device and the driving chip may be electrically connected in the following manner.

Referring to FIGs. 10 and 11, one of the third metal electrodes 3014 on the third source/drain regions 3012 is grounded, and the other is electrically connected to one of the fourth metal electrodes 3024 on the fourth source/drain regions 3022 and to the control electrode 14 of the bidirectional power device; the other one of the fourth metal electrodes 3024 on the fourth source/drain regions 3022 is connected to a voltage terminal V_{DD}. The third gate and the fourth gate are electrically connected together and connected to the same control voltage terminal Vᵢₙ.

One of the first metal electrodes 2014 on the first source/drain regions 2012 is electrically connected to the second power end of the bidirectional power device, and the other is electrically connected to one of the second metal electrodes 2024 and further connected to the substrate 200 of the bidirectional power device. The other one of the second metal electrodes 2024 is connected to the first power end of the bidirectional power device. The first gate 2013 and the second gate 2023 are electrically connected to the control electrode 14 of the bidirectional power device. The anode metal electrode 2033 is electrically connected to the substrate 200 of the bidirectional power device, and the cathode metal electrode 2034 is electrically connected to the control electrode 14 of the bidirectional power device.

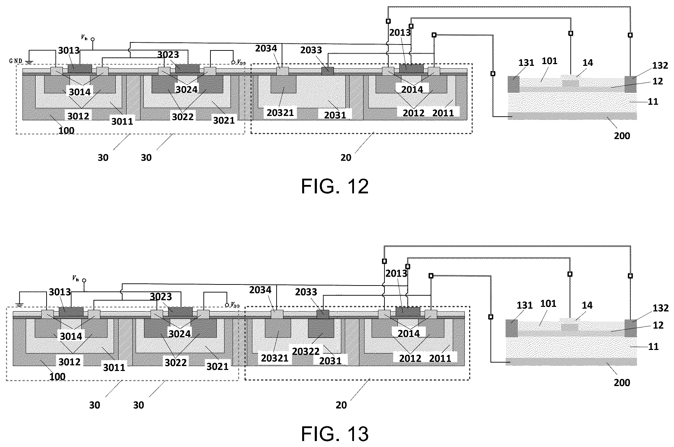

Referring to FIGs. 12 and 13, one of the third metal electrodes 3014 on the third source/drain regions 3012 is grounded, and the other is electrically connected to one of the fourth metal electrodes 3024 on the fourth source/drain regions 3022 and to the control electrode 14 of the bidirectional power device; the other one of the fourth metal electrodes 3024 on the fourth source/drain regions 3022 is connected to a voltage terminal V_{DD}. The third gate and the fourth gate are electrically connected together and connected to the same control voltage terminal Vᵢₙ.

One of the first metal electrodes 2014 on the first source/drain regions 2012 is electrically connected to the second power end of the bidirectional power device, and the other is electrically connected to the substrate 200 of the bidirectional power device. The first gate 2013 is electrically connected to the control electrode 14 of the bidirectional power device. The anode metal electrode 2033 is electrically connected to the substrate 200 of the bidirectional power device, and the cathode metal electrode 2034 is electrically connected to the control electrode 14 of the bidirectional power device.

Based on the above description, in embodiments of the present disclosure, the driving chip is fabricated on the first substrate, and simultaneously the bidirectional power device is fabricated on the second substrate. This enables an efficient production process while ensuring that the performance and reliability of the driving chip and the bidirectional power device meet application requirements.

Finally, it should be noted that the above embodiments are only used to illustrate the technical schemes of the present disclosure without limitation. Although the present disclosure is described in detail with reference to the foregoing embodiments, a person of ordinary skill in the art should understand that the technical solutions described in the foregoing embodiments can still be modified, or some or all of the technical features can be equivalently replaced; and these modifications or replacements do not make the essence of the corresponding technical solutions depart from the scope of the technical solutions of the embodiments of the present disclosure.

## Claims

1. A driving chip for driving a bidirectional power device and modulating a substrate potential of the bidirectional power device, the bidirectional power device comprising a first power end, a second power end, a control end, and a substrate potential end, comprising:
a driving circuit, and
a substrate potential modulation circuit;
wherein the driving circuit and the substrate potential modulation circuit are formed on a same substrate;
wherein the substrate potential modulation circuit is configured to receive signals from the control end and from the first power end and/or the second power end, and is coupled to the substrate potential end, such that a voltage at the substrate potential end of the bidirectional power device is substantially consistent with a lowest voltage among voltages at the control end, the first power end, and the second power end.

2. The driving chip according to claim 1, wherein the substrate potential modulation circuit comprises a switching module, a first end of the switching module is electrically coupled to whichever of the first power end or the second power end has the lower voltage, a second end of the switching module is electrically coupled to the substrate potential end of the bidirectional power device, and a control end of the switching module is electrically coupled to the control end of the bidirectional power device.

3. The driving chip according to claim 2, wherein the switching module comprises a first transistor, a first end of the first transistor is electrically coupled to one of the first power end and the second power end of the bidirectional power device, a second end of the first transistor is electrically coupled to the substrate potential end of the bidirectional power device, and a control end of the first transistor is electrically coupled to the control end of the bidirectional power device.

4. The driving chip according to claim 3, wherein the first transistor comprises a first well region of a first doping type that is located in the substrate, first source/drain regions of a second doping type that are located in the first well region, and a first gate that is disposed between the first source/drain regions; wherein the first gate is the control end of the first transistor.

5. The driving chip according to claim 3, wherein the switching module further comprises a second transistor, a first end of the second transistor is electrically coupled to the other one of the first power end and the second power end of the bidirectional power device, a second end of the second transistor is electrically coupled to the substrate potential end of the bidirectional power device, and a control end of the second transistor is electrically coupled to the control end of the bidirectional power device.

6. The driving chip according to claim 5, wherein the second transistor comprises a second well region of a first doping type that is located in the substrate, second source/drain regions of a second doping type that are located in the second well region, and a second gate that is disposed on an upper surface of the substrate and between the second source/drain regions; wherein the second gate is the control end of the second transistor.

7. The driving chip according to claim 5, wherein the switching module further comprises a diode, a cathode of the diode is electrically coupled to the control end of the first transistor and/or the control end of the second transistor, and an anode of the diode is electrically coupled to the substrate potential end of the bidirectional power device.

8. The driving chip according to claim 7, wherein the diode is configured as a PN junction diode or a Schottky diode.

9. The driving chip according to claim 1, wherein the driving circuit comprises a third transistor and a fourth transistor,
wherein a second end of the third transistor is electrically coupled to a first end of the fourth transistor, and is further electrically coupled to the substrate potential end and the control end of the bidirectional power device, so as to drive the bidirectional power device;
wherein a control end of the third transistor is electrically connected to a control end of the fourth transistor.

10. A bidirectional power apparatus, comprising a bidirectional power device, and a driving chip according to any one of claims 1 to 9, wherein the driving chip is configured to drive the bidirectional power device and to modulate the substrate potential of the bidirectional power device.

11. A method for manufacturing a driving chip, comprising:
providing a substrate; and
forming a driving circuit and a substrate potential modulation circuit in the substrate, wherein the driving circuit is configured to drive a bidirectional power device, and the substrate potential modulation circuit is configured to modulate a substrate potential of the bidirectional power device;
wherein the bidirectional power device comprises a first power end, a second power end, a control end, and a substrate potential end;
wherein the substrate potential modulation circuit is configured to receive signals from the control end and from the first power end and/or the second power end, and is connected to the substrate potential end, such that the substrate potential end of the bidirectional power device is substantially consistent with a lowest voltage among voltages at the control end, the first power end and the second power end.

12. The method according to claim 11, wherein the substrate potential modulation circuit comprises a first transistor and/or a second transistor, and the driving circuit comprises a third transistor and a fourth transistor;
wherein forming the driving circuit and the substrate potential modulation circuit in the substrate comprises:
simultaneously forming first source/drain regions and/or second source/drain regions, and third source/drain regions, and forming fourth source/drain regions in the substrate, wherein first source/drain regions and/or second source/drain regions, and third source/drain regions have same dopant ion types, the first source/drain regions are configured as a first end and a second end of the first transistor, the second source/drain regions are configured as a first end and a second end of the second transistor, the third source/drain regions are configured as a first end and a second end of the third transistor, and the fourth source/drain regions are configured as a first end and a second end of the fourth transistor; and
simultaneously forming a first gate and/or a second gate, a third gate, and a fourth gate on an upper surface of the substrate, wherein the first gate is configured as a control end of the first transistor, the second gate is configured as a control end of the second transistor, the third gate is configured as a control end of the third transistor, and the fourth gate is configured as a control end of the fourth transistor,
wherein the first end of the first transistor is coupled to the first power end and/or the first end of the second transistor are coupled to the second power end, the second end of the first transistor and the second end of the second transistor are coupled to the substrate potential end, the control end of the first transistor and the control end of the second transistor are electrically coupled to the control end of the bidirectional power device,
wherein the first end of the third transistor is coupled to the second end of the four transistor, is further electrically coupled to the substrate potential end and the control end of the bidirectional power device.

13. The method according to claim 12, wherein simultaneously forming the first source/drain regions and/or the second source/drain regions, the third source/drain regions, and the fourth source/drain regions in the substrate comprises:
simultaneously forming a first well region and/or a second well region and a third well region, and forming a fourth well region in the substrate; and
forming the first source/drain regions in the first well region and/or the second source/drain regions in the second well region, the third source/drain regions in the third well region, and the fourth source/drain regions in the fourth well region,
wherein the first well region ,the second well region and the third well region have same dopant ion types, the third well region and the fourth well region have opposite dopant ion types.

14. The method according to claim 13, wherein the substrate potential modulation circuit further comprises a diode;
the method comprises:
forming a fifth well region in the substrate;
forming a first doped region and/or a second doped region in the fifth well region,
forming an anode metal electrode and a cathode metal electrode on an upper surface of the fifth well region;
wherein the fifth well region has a dopant ion type opposite to that of the first well region and the second well region, wherein the first doped region and the second doped region have opposite dopant ion types, the first doped region and the fifth well region have same dopant ion types,
wherein the cathode metal electrode is formed on an upper surface of the first doped region and is electrically connected to the first doped region and the control end of the bidirectional power device, and the anode metal electrode is electrically connected to the fifth well region or the second doped region, and electrically connected to the substrate potential end.

15. A method for manufacturing a bidirectional power apparatus, the bidirectional power apparatus comprising a bidirectional power device and a driving chip according to any one of claims 1 to 9;
wherein the method comprises:
providing a first substrate and a second substrate; and
fabricating the driving chip on the first substrate, and fabricating the bidirectional power device on the second substrate.
